# EUROPÄISCHE PATENTANMELDUNG

(11) **EP 3 680 792 A1**
(43) Veröffentlichungstag der Anmeldung: **15.07.2020**
(21) Anmeldenummer: 19151209.4
(22) Anmeldetag: 10.01.2019
(51) Int. Cl.: G06F 17/50

(54) **KOPPELN EINES SIMULATIONSMODELLS MIT EINER STEUERUNGSKOMPONENTE MITTELS EINER INTERAKTIVEN ANZEIGEVORRICHTUNG**

(71) Anmelder: Siemens Aktiengesellschaft, 80333 München (DE)
(72) Erfinder: Baudisch, Thomas, 86938 Schondorf am Ammersee (DE)

(57) **Zusammenfassung**

Verfahren, interaktive Anzeigevorrichtung (INT), und Vorrichtung (300) zum Koppeln eines Simulationsmodells (100) eines technischen Systems mit einer Steuerungskomponente des technischen Systems, wobei Ein- und Ausgänge (E100, A100) des Simulationsmodells (100) und Ein- und Ausgänge (E200, A200) der Steuerungskomponente (200) ermittelt und mittels der interaktiven Anzeigevorrichtung (INT) dargestellt werden. Anhand der Darstellung der Ein- und Ausgänge (E200, A200) der Steuerungskomponente und der Darstellung der Ein- und Ausgänge (E100, A100) des Simulationsmodells und abhängig von einer jeweils zugeordneten Signaleingangs- und Signalausgangsinformation, werden die Ausgänge (A200) der Steuerungskomponente zu geeigneten Eingängen (E100) des Simulationsmodells und/oder Eingänge (E200) der Steuerungskomponente zu geeigneten Ausgängen (A100) des Simulationsmodells zugeordnet und zum Steuern des Simulationsmodells (100) des realen technischen Systems durch die Steuerungskomponente (200) gekoppelt.

## Beschreibung

Die Erfindung betrifft ein Verfahren zum Koppeln eines Simulationsmodells, insbesondere eines computergestützten Simulationsmodells, eines realen technischen Systems mit einer Steuerungskomponente des technischen Systems.

Zum Testen der Funktionsweise einer Steuerung eines technischen Systems, wie z.B. einer Maschine oder einer Anlage, ist die sogenannte Hardware-in-the-Loop-Simulation (Abkürzung: HiL, HIL oder HITL) bekannt, wobei ein computergestütztes Simulationsmodell des technischen Systems mittels der realen (Hardware-)Steuerung gesteuert wird, auch als Co-Simulation bezeichnet. Die Simulation kann insbesondere in Echtzeit durchgeführt werden. Zweck der Hardware-in-the-Loop-Simulation kann die Prüfung oder Validierung eines Regelungsalgorithmus oder der Steuerungslogik sein. Die Signaleingänge und Signalausgänge der Steuerungshardware werden dazu mit den entsprechenden Signaleingängen und Signalausgängen des Simulationsmodells gekoppelt, wobei das Simulationsmodell ein oder mehrere virtuelle Modelle umfassen kann. Den Eingängen der Steuerung werden simulierte Sensordaten aus dem Simulationsmodell übergeben. Die Ausgangssignale der Ausgänge der Steuerung werden an das Simulationsmodell zurückgegeben. In anderen Worten, die Simulation generiert die Sensorsignale und bildet das Verhalten der Aktorik nach. Um ein Hardware-in-the-Loop-Modell aufzusetzen ist demnach in der Regel eine Verknüpfung bzw. Verschaltung der Ein- und Ausgangssignale zwischen realer Steuerungshardware und Simulationsmodell notwendig, wobei die Verknüpfung insbesondere in der Regel manuell durchgeführt wird. Dies kann insbesondere bei komplexen technischen Systemen zeitaufwändig und fehleranfällig sein.

Zur Darstellung von computergenerierten Inhalten sind insbesondere Displays, transparente Displays (engl. See-through display), ein Gerät zur Darstellung einer virtuellen (engl. Virtual reality, VR) oder erweiterten Realität (engl. Augmented reality, AR), ein Smartphone oder ein Tablett-Computer oder ähnliches bekannt.

Es ist eine Aufgabe der vorliegenden Erfindung, das Einrichten einer Hardware-in-the-Loop-Simulation zu erleichtern.

Die Aufgabe wird durch die in den unabhängigen Ansprüchen beschriebenen Maßnahmen gelöst. In den abhängigen Ansprüchen sind vorteilhafte Weiterbildungen der Erfindung dargestellt.

Gemäß einem ersten Aspekt betrifft die Erfindung ein Verfahren zum Koppeln eines Simulationsmodells eines realen technischen Systems mit einer Steuerungskomponente des technischen Systems mittels einer interaktiven Anzeigevorrichtung, umfassend die folgenden Verfahrensschritte:
- Ermitteln von Eingängen mit einer jeweils zugeordneten Signaleingangsinformation und Ausgängen mit einer jeweils zugeordneten Signalausgangsinformation des Simulationsmodells,
- Ermitteln von Eingängen mit einer jeweils zugeordneten Signaleingangsinformation und Ausgängen mit einer jeweils zugeordneten Signalausgangsinformation der Steuerungskomponente,
- Darstellen der Ein- und Ausgänge der Steuerungskomponente und der Ein- und Ausgänge des Simulationsmodells mittels der interaktiven Anzeigevorrichtung,
- Zuordnen von Ausgängen der Steuerungskomponente zu geeigneten Eingängen des Simulationsmodells und/oder Eingänge der Steuerungskomponente zu geeigneten Ausgängen des Simulationsmodells anhand der Darstellung der Ein- und Ausgänge der Steuerungskomponente und der Darstellung der Ein- und Ausgänge des Simulationsmodells und abhängig von der jeweils zugeordneten Signaleingangs- und Signalausgangsinformation
   und
- Koppeln der Ein- und Ausgänge der Steuerungskomponente mit den zugeordneten Ein- und Ausgängen des Simulationsmodells zum Steuern des Simulationsmodells des realen technischen Systems durch die Steuerungskomponente.

Das Verfahren kann insbesondere computergestützt bzw. zumindest teilweise computerimplementiert sein, d.h. zumindest Teile des Verfahrens können mittels eines Computers realisiert werden.

Gemäß einem zweiten Aspekt betrifft die Erfindung eine interaktive Anzeigevorrichtung, die mindestens eine Anzeigeeinheit und mindestens eine Benutzerschnittstelle umfasst,
- wobei die Anzeigeeinheit derart eingerichtet ist, Ein- und Ausgänge einer Steuerungskomponente und Ein- und Ausgänge eines Simulationsmodells eines realen technischen Systems darzustellen,
- wobei die Benutzerschnittstelle derart eingerichtet ist, die Ausgänge der Steuerungskomponente zu geeigneten Eingängen des Simulationsmodells und/oder Eingänge der Steuerungskomponente zu geeigneten Ausgängen des Simulationsmodells anhand der Darstellung der Ein- und Ausgänge der Steuerungskomponente und der Darstellung der Ein- und Ausgänge des Simulationsmodells und abhängig von einer jeweils zugeordneten Signaleingangs- und Signalausgangsinformation zuzuordnen.

Eine interaktive Anzeigevorrichtung kann insbesondere ein transparentes Display (engl. See-through display), ein Gerät zur Darstellung einer virtuellen (engl. Virtual reality, VR) oder erweiterten Realität (engl. Augmented reality, AR), ein Smartphone oder ein Tablet-Computer sein. Die interaktive Anzeigevorrichtung umfasst insbesondere eine Anzeigeeinheit, z.B. einen Bildschirm, und eine Benutzerschnittstelle, z.B. eine Eingabemöglichkeit für einen Benutzer.

Die interaktive Anzeigevorrichtung kann insbesondere derart eingerichtet sein, das Einrichten einer Hardware-in-the-Loop-Simulation zu realisieren und insbesondere zu vereinfachen. Dazu kann der interaktiven Anzeigevorrichtung ein Simulationsmodell, insbesondere ein computergestütztes Simulationsmodell, eines zu steuernden technischen Systems bereitgestellt werden. Insbesondere können Signaleingänge und Signalausgänge des Simulationsmodells mittels der Anzeigeeinheit visualisiert werden. Zum Steuern des Simulationsmodells mittels eines Hardware-in-the-Loop-Verfahrens wird eine reale Steuerungskomponente bereitgestellt. Die Signaleingänge und Signalausgänge der Steuerungskomponente können insbesondere durch eine jeweils zugeordnete Signaleingangs- und Signalausgangsinformation gekennzeichnet sein. Im Folgenden sind mit "Eingängen" und "Ausgängen" insbesondere "Signaleingänge" bzw. "Signalausgänge" gemeint, d.h. die physikalischen Schnittstellen zur Übertragung von elektrischen Signalen. Die Ein- und Ausgänge können mittels der interaktiven Anzeigevorrichtung beispielsweise rein schematisch dargestellt werden, wobei insbesondere die jeweilige Signaleingangs- und Signalausgangsinformation berücksichtigt - z.B. hinterlegt, verlinkt, angezeigt, etc.- wird.

Um die Hardware-in-the-Loop-Simulation durchzuführen, können geeignete Eingänge bzw. Ausgänge der Steuerungskomponente den Eingängen und Ausgängen des Simulationsmodells zugeordnet werden, wobei die Zuordnung vorzugsweise anhand einer Darstellung der jeweiligen Ein- und Ausgänge durch die interaktive Anzeigevorrichtung und abhängig von einer den jeweiligen Ein- und Ausgängen zugeordneter Signaleingangs- und Signalausgangsinformation erfolgt. Eingänge und Ausgänge sind insbesondere geeignet, um zueinander zugeordnet zu werden, wenn beispielsweise ihre entsprechenden Signaleingangs- bzw. Signalausgangsinformation eine Zuordnung erlaubt. Vorzugsweise kann die Darstellung der Ein- bzw. Ausgänge derart gewählt werden, dass die jeweils zugeordnete Signaleingangs- bzw. Signalausgangsinformation eindeutig aus der Darstellung ersichtlich ist, wie z.B. durch eine zugeordnete Bezeichnung.

Eine Signaleingangs- bzw. Signalausgangsinformation eines jeweiligen Signaleingangs bzw. Signalausgangs der Steuerungskomponente oder des Simulationsmodells umfasst insbesondere Information zur korrekten Zuordnung geeigneter Ein- bzw. Ausgänge, wie z.B. Eingangs- bzw. Ausgangsgrößen. Beispielsweise kann eine Signalausgangsinformation eines Ausgangs der Steuerungskomponente eine Information über einen anzusteuernden Aktor des technischen Systems umfassen. Ein geeigneter Eingang des Simulationsmodells kann eine entsprechende Signaleingangsinformation umfassen, so dass eine Zuordnung zu einem entsprechenden Ausgang möglich ist.

Es ist ein Vorteil der vorliegenden Erfindung, dass mittels der interaktiven Anzeigevorrichtung alle relevanten Informationen, die zum Einrichten einer Hardware-in-the-Loop-Simulation benötigt werden, dargestellt werden. Dies ermöglicht insbesondere eine übersichtliche Darstellung der verschiedenen Ein- und Ausgänge. Abhängig von der jeweiligen Signaleingangs- und Signalausgangsinformation kann auf einfache Weise eine korrekte, d.h. geeignete, Zuordnung und anschließende Kopplung der Ein- und Ausgänge durchgeführt werden. Die Zuordnung und/oder die Kopplung der Ein- und Ausgänge kann insbesondere mittels der interaktiven Anzeigevorrichtung durchgeführt werden.

Mittels der interaktiven Anzeigevorrichtung kann eine korrekte Zuordnung der Signaleingänge und -ausgänge der Steuerungshardware zu den entsprechenden Signaleingängen und -ausgängen des Simulationsmodells des zu steuernden technischen Systems auf einfache Weise ermöglicht werden. Die interaktive Anzeigevorrichtung ermöglicht die Darstellung der entsprechend benötigten Information zur Kopplung der Signaleingänge und - ausgänge für einen Signalaustausch. So kann vorteilhaft ein direkter Bezug zur Hardware erzielt werden. Fehler bei der Kopplung der Signaleingänge und -ausgänge können vermieden bzw. frühzeitig erkannt werden, da die Darstellung durch die interaktive Anzeigevorrichtung eine Fehlersuche deutlich vereinfacht.

In einer vorteilhaften Ausführungsform des Verfahrens kann die Steuerungskomponente mittels eines Sensors erfasst werden, wobei die Sensordaten mindestens eine Typinformation der Steuerungskomponente umfassen und anhand der Typinformation die Ein- und Ausgänge der Steuerungskomponente ermittelt werden.

Mittels eines Sensors können Daten, z.B. Bilddaten, der Steuerungskomponente erfasst werden und an die interaktive Anzeigevorrichtung übermittelt werden. Beispielsweise kann anhand von Bilddaten eine Typinformation der Steuerungskomponente abgeleitet werden. Vorzugsweise umfassen die Sensordaten mindestens eine Typinformation der Steuerungskomponente, wobei aus der Typinformation insbesondere die Signaleingangs- und Signalausgangsinformation abgeleitet werden kann bzw. die Typinformation die Signaleingangs- und Signalausgangsinformation umfasst.

In einer weiteren vorteilhaften Ausführungsform des Verfahrens können die Ein- und Ausgänge der Steuerungskomponente anhand eines computergestützten Modells der Steuerungskomponente ermittelt werden.

Ein computergestütztes Modell der Steuerungskomponente kann beispielsweise ein dreidimensionales (3D) CAD-Modell (engl. Computer-aided-design, CAD) sein. Beispielsweise können Bilddaten der Steuerungskomponente mit dem Modell verglichen werden. Anhand des Modells können entsprechende Ein- und Ausgänge der Steuerungskomponente bestimmt werden. Diese Information kann der interaktiven Anzeigevorrichtung zum Darstellen der Ein- und Ausgänge der Steuerungskomponente übermittelt werden.

In einer weiteren vorteilhaften Ausführungsform des Verfahrens können die Ein- und Ausgänge der Steuerungskomponente anhand einer Spezifikation der Steuerungskomponente und/oder einem der Steuerungskomponente zugeordneten Erkennungsmusters ermittelt werden.

Eine Spezifikation kann beispielsweise eine Angabe über die Steuerungskomponente, eine Steuerungsprojektierung, ein Datenblatt oder eine Betriebsanleitung sein. Die Spezifikation kann beispielsweise Informationen über die Ein- und Ausgänge, wie z.B. räumlichen Lage, Typinformation, etc., umfassen. Ein Erkennungsmuster kann beispielsweise ein Strichcode oder ein zwei- oder dreidimensionaler Code sein, welcher Informationen über die Steuerungskomponente kodiert umfasst. Das Erkennungsmuster kann vorzugsweise mit einem geeigneten Sensor erfasst und gelesen werden, der mit der interaktiven Anzeigevorrichtung gekoppelt ist.

In einer weiteren vorteilhaften Ausführungsform des Verfahrens können mindestens eine Typinformation der Steuerungskomponente und/oder Signalausgangs- und/oder Signaleingangsinformation der jeweils zugeordneten Ein- und Ausgänge der Steuerungskomponente und/oder Ein- und Ausgängen des Simulationsmodells zusätzlich ausgegeben werden.

Beispielsweise kann eine Liste in Form einer Datei oder eine Übersicht der zugeordneten Ein- und Ausgänge ausgegeben und beispielsweise mittels der interaktiven Anzeigevorrichtung angezeigt werden.

In einer weiteren vorteilhaften Ausführungsform des Verfahrens können
- mittels der interaktiven Anzeigevorrichtung ein Teil der Steuerungskomponente selektiert wird,
- lediglich die Ein- und Ausgänge des selektierten Teils der Steuerungskomponente dargestellt werden
   und
- lediglich zu diesen Ein- und Ausgängen geeignete Ein- und Ausgänge des Simulationsmodells zugeordnet werden.

Beispielsweise kann die interaktive Anzeigevorrichtung lediglich einen Teil der Steuerungskomponente abbilden bzw. mittels eines Sensors lediglich einen Teil der Steuerungskomponente und/oder selektierte Ein- und Ausgänge erfassen. Vorzugsweise können mittels der interaktiven Anzeigevorrichtung lediglich diejenigen Ein- und Ausgänge des Simulationsmodells angezeigt werden, welche für eine Zuordnung zu den Ein- und Ausgängen des selektierten Teils der Steuerungskomponente geeignet sind. Ein Anwender der interaktiven Anzeigevorrichtung kann insbesondere diese derart nutzen, dass lediglich ein Teil der vorhandenen Ein- und Ausgänge der Steuerungskomponente für den Anwender angezeigt wird. Es kann eine Selektion mittels der interaktiven Anzeigevorrichtung vorgenommen werden. Eine Selektion kann insbesondere die Zuordnung der geeigneten Ein- und Ausgänge übersichtlicher gestalten und/oder vereinfachen.

In einer weiteren vorteilhaften Ausführungsform des Verfahrens kann das Simulationsmodell des realen technischen Systems durch die Steuerungskomponente gesteuert werden.

Vorzugsweise kann nach der Kopplung der Steuerungskomponente und des Simulationsmodells über die geeigneten jeweiligen Ein- und Ausgänge eine Hardware-in-the-Loop-Simulation durchgeführt werden, wobei über die gekoppelten Ein- und Ausgänge Signale ausgetauscht werden können. Insbesondere kann die Hardware-in-the-Loop-Simulation in Echtzeit durchgeführt werden.

In einer vorteilhaften Ausführungsform kann die interaktive Anzeigevorrichtung mindestens einen Sensor umfassen und/oder mit mindestens einem Sensor gekoppelt sein, wobei der Sensor derart eingerichtet ist, die Steuerungskomponente zu erfassen und Sensordaten, die mindestens eine Typinformation der Steuerungskomponente umfassen, an die interaktive Anzeigevorrichtung zu übermitteln.

In einer weiteren vorteilhaften Ausführungsform kann die interaktive Anzeigevorrichtung derart eingerichtet sein, einen Teil der Steuerungskomponente zu selektieren, lediglich die Ein- und Ausgänge des selektierten Teils der Steuerungskomponente darzustellen und lediglich zu diesen Ein- und Ausgängen der Steuerungskomponente geeignete Ein- und Ausgänge des Simulationsmodells zuzuordnen.

Gemäß einem weiteren Aspekt betrifft die Erfindung eine Vorrichtung zum Koppeln eines Simulationsmodells eines realen technischen Systems mit einer Steuerungskomponente des technischen Systems, wobei die Vorrichtung mindestens einen Prozessor und eine interaktive Anzeigevorrichtung umfasst und derart eingerichtet ist, die Schritte eines erfindungsgemäßen Verfahrens durchzuführen.

Unter einem "Prozessor" können im Zusammenhang mit der Erfindung beispielsweise eine Maschine oder eine elektronische Schaltung verstanden werden. Bei einem Prozessor kann es sich insbesondere um einen Hauptprozessor (engl. Central Processing Unit, CPU), einen Mikroprozessor oder einen Mikrokontroller, beispielsweise eine anwendungsspezifische integrierte Schaltung oder einen digitalen Signalprozessor, möglicherweise in Kombination mit einer Speichereinheit zum Speichern von Programmbefehlen, ein Server etc. handeln. Der Prozessor und die interaktive Anzeigevorrichtung können insbesondere derart miteinander gekoppelt sein, dass Daten bzw. Informationen übermittelt werden können.

Des Weiteren betrifft die Erfindung ein Computerprogrammprodukt, das direkt in einen programmierbaren Computer ladbar ist, umfassend Programmcodeteile, die bei der Ausführung des Programms durch einen Computer diesen veranlassen, das Verfahren und/oder zumindest teilweise die Schritte eines Verfahrens auszuführen und ein computerlesbares Speichermedium mit einem erfindungsgemäßen Computerprogrammprodukt.

Ein Computerprogrammprodukt kann beispielsweise auf einem Speichermedium, wie z.B. Speicherkarte, USB-Stick, CD-ROM, DVD, ein nichtflüchtiger/dauerhaftes Speichermedium (engl. Non-transitory storage Medium) oder auch in Form einer herunterladbaren Datei von einem Server in einem Netzwerk bereitgestellt oder geliefert werden.

Ausführungsbeispiele des erfindungsgemäßen Verfahrens und der erfindungsgemäßen Vorrichtung sind in den Figuren beispielhaft dargestellt und werden anhand der nachfolgenden Beschreibung näher erläutert. Es zeigen:
Fig. 1: ein Ablaufdiagramm eines erfindungsgemäßen Verfahrens; und
Fig. 2: eine schematische Darstellung einer erfindungsgemäßen interaktiven Anzeigevorrichtung und Vorrichtung zum Koppeln eines Simulationsmodells mit einer Steuerungskomponente.

Einander entsprechende Gegenstände sind in allen Figuren mit den gleichen Bezugszeichen versehen.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf. Insbesondere können diese gebräuchlichen und dem Fachmann bekannten Realisierungsvarianten ausschließlich per Hardware(komponenten) oder ausschließlich per Software(komponenten) realisiert werden. Alternativ und/oder zusätzlich kann der Fachmann im Rahmen seines fachmännischen Könnens weitestgehend beliebige erfindungsgemäße Kombinationen aus Hardware(komponenten) und Software(komponenten) wählen, um erfindungsgemäße Realisierungsvarianten umzusetzen.

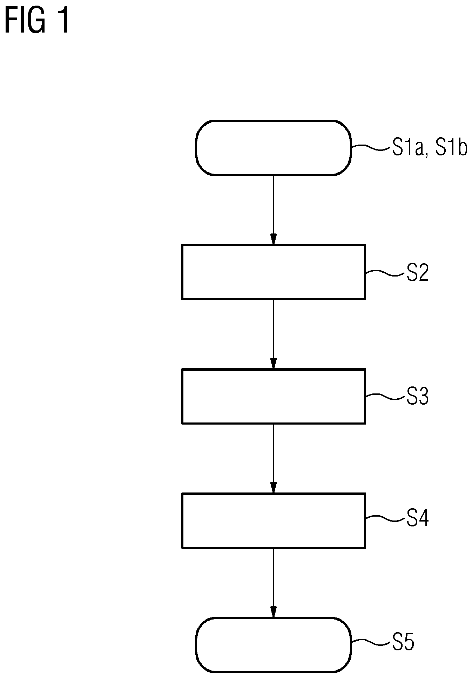

Figur 1 zeigt ein Ablaufdiagramm eines erfindungsgemäßen Verfahrens zum Koppeln eines Simulationsmodells eines realen technischen Systems mit einer Steuerungskomponente. Das Verfahren kann insbesondere dafür geeignet sein, eine Hardware-in-the-Loop-Simulation zu erstellen und durchzuführen.

Ein reales technisches System kann beispielsweise eine verfahrenstechnische Anlage, eine Werkzeugmaschine oder Fertigungseinrichtung sein. Die Steuerungskomponente kann beispielsweise eine programmierbare Steuerung sein. Beispielsweise ist die Steuerungskomponente in einem Schaltschrank integriert. Die Steuerungskomponente ist mit dem technischen System gekoppelt. Um beispielsweise die Steuerungskomponente zu testen, kann eine Hardware-in-the-Loop-Simulation durchgeführt werden. Dazu kann ein computergestütztes Simulationsmodell des technischen Systems bereitgestellt werden. Das computergestützte Simulationsmodell kann beispielsweise auf einem Computer ausgeführt werden, wobei für die Durchführung der Simulation die Signaleingänge und Signalausgänge der Steuerungskomponente und des Simulationsmodells korrekt miteinander verknüpft werden müssen.

In den ersten Schritten Sla und S1b des Verfahrens werden die vorhandenen Signaleingänge und Signalausgänge sowohl der Steuerungskomponente als auch des Simulationsmodells ermittelt. Beispielsweise kann die Steuerungskomponente mittels einer Kamera erfasst werden. Die erfassten Kameradaten können insbesondere eine Typinformation der Steuerungskomponente umfassen, wie z.B. Art der Steuerungskomponente. Anhand der Typinformation kann mindestens eine Signaleingangs- oder Signalausgangsinformation bestimmt und daraus die entsprechenden Signaleingänge und die Signalausgänge der Steuerungskomponente abgeleitet werden. Die Signaleingangs- und Signalausgangsinformationen geben beispielsweise Informationen über die Art der Ein- bzw. Ausgangssignale, d.h. relevante Information für die korrekte Verknüpfung.

Die Signaleingänge und die Signalausgänge der Steuerungskomponente können außerdem anhand einer Spezifikation der Steuerungskomponente und/oder anhand eines computergestützten Modells der Steuerungskomponente und/oder anhand eines Erkennungsmusters ermittelt werden. Beispielsweise kann ein CAD-Modell der Steuerungskomponente bereitgestellt, z.B. von einer Datenbank abgerufen, werden. Insbesondere kann anhand eines Erkennungsmusters, das vorzugsweise eindeutige Informationen über die reale Steuerungskomponente umfasst, ein entsprechendes CAD-Modell für die Steuerungskomponente ermittelt werden.

Die Signaleingänge und Signalausgänge können sich auf der Rückseite der Steuerungskomponente befinden, so dass beispielsweise eine Kamera diese nicht direkt erfassen kann. Das Kamerabild kann mit einem 3D CAD Modell der Steuerungskomponente in Deckung gebracht werden, so dass auf der Basis des 3D CAD Modells die Steuerungskomponenten und dessen Ein- und Ausgänge identifiziert werden können.

Die ermittelten Signaleingänge und die Signalausgänge der Steuerungskomponente und die Signaleingänge und die Signalausgänge des Simulationsmodells können im nächsten Schritt S2 mittels einer interaktiven Anzeigevorrichtung dargestellt werden. Beispielsweise können diese grafisch auf einem Display dargestellt werden, wobei insbesondere Signaleingangs- und Signalausgangsinformationen der jeweiligen Signaleingänge und die Signalausgänge angegeben oder geeignet gekennzeichnet sind. Vorzugsweise ist die interaktive Anzeigevorrichtung mit der Kamera derart gekoppelt, dass Kameradaten an die interaktive Anzeigevorrichtung übermittelt werden können.

Unter einer "interaktiven Anzeigevorrichtung" kann insbesondere eine Anzeigevorrichtung verstanden werden, die mindestens einen Prozessor umfasst und derart eingerichtet ist, Informationen grafisch darzustellen bzw. zu visualisieren. Die interaktive Anzeigevorrichtung weist eine Benutzerschnittstelle auf, die einem Benutzer Eingabemöglichkeiten bietet, wie z.B. über ein Touch-Display oder ähnliches, wobei die Anzeige der Information vorzugsweise mittels der Eingabemöglichkeit manipulierbar ist.

Im nächsten Schritt S3 wird eine korrekte Zuordnung der Signaleingänge und Signalausgänge der Steuerungskomponente zu geeigneten Signaleingängen und Signalausgängen des Simulationsmodells durchgeführt. Die Zuordnung erfolgt anhand der Darstellung der Signaleingänge und der Signalausgänge der Steuerung und des Simulationsmodells durch die interaktive Anzeigevorrichtung und in Abhängigkeit der jeweils den Signaleingängen und Signalausgängen zugeordneten Signaleingangs- bzw. Signalausgangsinformation. Vorzugsweise werden die zu koppelnden Ein- und Ausgänge mittels der interaktiven Anzeigevorrichtung übersichtlich dargestellt, so dass eine jeweilige geeignete Zuordnung bestimmt werden kann. Beispielsweise kann die Zuordnung manuell mittels eines Touchpads erfolgen, wobei eine grafische Verbindung der dargestellten Ein- und Ausgänge erstellt und angezeigt werden kann.

Im folgenden Schritt S4 können die zugeordneten Eingänge der Steuerungskomponente mit den Ausgängen des Simulationsmodells und zugeordneten die Ausgänge der Steuerungskomponente mit den Eingängen des Simulationsmodells gekoppelt, d.h. verschaltet werden, so dass Signale bzw. Daten ausgetauscht werden können. Dies kann beispielsweise durch Ziehen einer Verbindung zwischen Ein- und Ausgangssignal mit dem Finger oder Eingabestift erfolgen oder mit einer geeigneten Software, die die zugeordneten Ein- und Ausgänge derart miteinander verknüpft, so dass eine Steuerung des Simulationsmodells durch die Steuerungskomponente möglich ist.

Die Durchführung der Hardware-in-the-Loop-Simulation erfolgt im nächsten Schritt S5, wobei das Simulationsmodell durch die gekoppelte Steuerungskomponente angesteuert wird. Vorzugsweise ist das Simulationsmodell für eine Echtzeit-Simulation geeignet. Das Simulationsmodell generiert bei der Durchführung der Hardware-in-the-Loop-Simulation die Sensorsignale und bildet die Aktorik des realen technischen Systems nach.

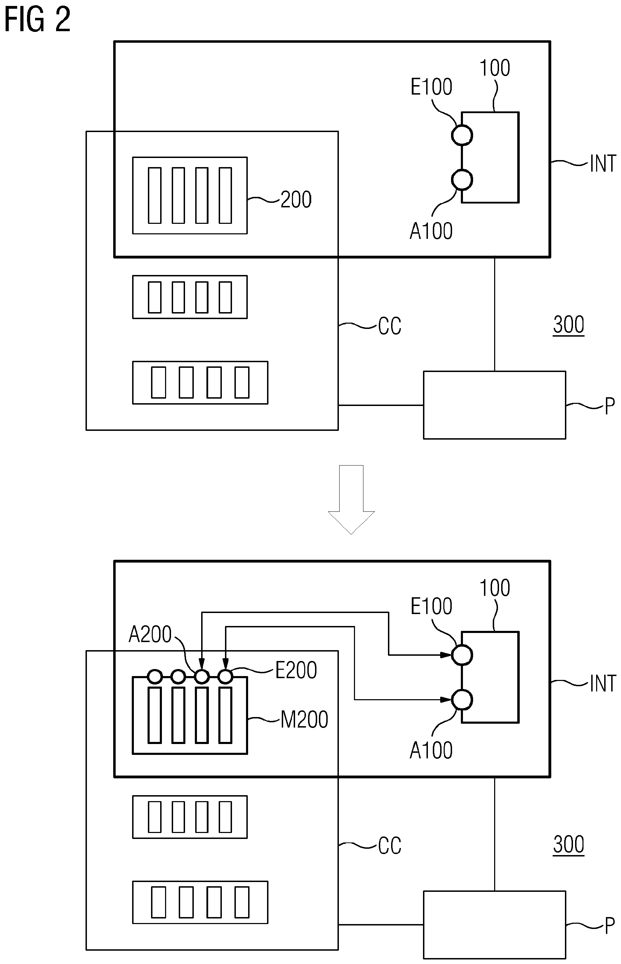

Figur 2 zeigt in schematischer Darstellung eine erfindungsgemäße interaktive Anzeigevorrichtung INT, eine Vorrichtung 300, die derart eingerichtet ist, ein erfindungsgemäßes Verfahren zum Koppeln eines Simulationsmodells 100 eines realen technischen Systems mit einer Steuerungskomponente 200 mittels der interaktiven Anzeigevorrichtung INT durchzuführen. Figur 2 zeigt sowohl schematisch den Aufbau der Vorrichtung als auch Schritte eines erfindungsgemäßen Verfahrens.

Die interaktive Anzeigevorrichtung INT kann beispielsweise ein transparentes Display oder ein Bildschirm eines Computers oder eine VR/AR-Brille sein. Die interaktive Anzeigevorrichtung INT umfasst eine Anzeigeeinheit und eine Bedienschnittstelle, die beispielsweise als ein berührungsempfindliches Display realisiert sein können. Die Vorrichtung 300 zum Durchführen eines erfindungsgemäßen Verfahrens umfasst die interaktive Anzeigevorrichtung INT und mindestens einen Prozessor P. Die Vorrichtung 300 kann beispielsweise auch ein Computer mit Anzeigeeinheit sein, wie z.B. ein Smartphone oder ein Tablett. Vorzugsweise ist die interaktive Anzeigevorrichtung mit mindestens einem Sensor, wie z.B. einer Kamera gekoppelt.

Im Folgenden wird die interaktive Anzeigevorrichtung INT beispielhaft als ein transparentes Display beschrieben. Das transparente Display INT erlaubt, Gegenstände, die sich vom Betrachter aus hinter dem Display befinden, durch dieses hindurch zu sehen, wobei zusätzlich Informationen auf dem Display angezeigt werden können. Des Weiteren umfasst das transparente Display INT eine Bedienschnittstelle; beispielsweise ist es berührungsempfindlich.

Figur 2 zeigt weiter schematisch einen Schaltschrank CC, der insbesondere mindestens eine Steuerungskomponente 200 umfasst, deren Funktionsfähigkeit mittels einer Hardware-in-the-Loop-Simulation geprüft werden soll. Die Steuerungskomponente 200 und das transparente Display INT sind über Kommunikationsverbindungen mit mindestens einem Prozessor P gekoppelt. Auf dem Prozessor P kann insbesondere das Simulationsmodell 100 des durch die Steuerungskomponente 200 zu steuernden technischen Systems gespeichert sein. Die Simulation kann insbesondere auch auf einem weiteren Prozessor (nicht dargestellt) durchgeführt werden.

Das transparente Display INT kann insbesondere Informationen des Simulationsmodells 100 darstellen. In Figur 2 ist schematisch gezeigt, dass Signaleingänge E100 und Signalausgänge A100 des Simulationsmodells 100 mittels des transparenten Displays schematisch dargestellt werden können. Vorzugsweise umfasst die Darstellung Signaleingangs- und Signalausgangsinformationen für die jeweiligen Signaleingänge und -ausgänge E100, A100, beispielsweise in Form einer geeigneten Kennzeichnung.

Wenn das transparente Display INT vor den Schaltschrank CC gehalten wird, wird zusätzlich durch das Display ein Teil des Schaltschranks, beispielsweise die Steuerungskomponente 200, sichtbar. Somit ermöglicht das transparente Display INT eine gleichzeitige Betrachtung der realen Steuerungskomponente 200 und der Information des Simulationsmodells 100 des zu steuernden technischen Systems.

Für die Durchführung einer Hardware-in-the-Loop-Simulation wird eine korrekte Zuordnung der Ein- und Ausgänge der Steuerungskomponente 200 zu den geeigneten Ein- und Ausgängen des Simulationsmodells 100 benötigt. Das transparente Display ist insbesondere derart eingerichtet, zusätzlich die Ein- und Ausgänge E200, A200 der Steuerungskomponente 200 auf dem transparenten Display INT darzustellen. Vorzugsweise werden die Ein- und Ausgänge E200, A200 mit Bezug, z.B. als Überlagerung, zum realen Bild der Steuerungskomponente 200 dargestellt.

Der Bildausschnitt des transparenten Displays INT erlaubt außerdem eine Selektion der Steuerungskomponente 200. Es können beispielsweise lediglich diejenigen Ein- und Ausgänge E200, A200 der selektierten Steuerungskomponente 200 dargestellt werden, die mittels des transparenten Displays direkt von einem Benutzer betrachtet wird.

Auf der Steuerungskomponente 200 kann beispielsweise ein Erkennungsmuster, wie z.B. ein Strichcode, angebracht sein, um mittels eines Sensors, der mit dem transparenten Display gekoppelt ist, Informationen über die Steuerungskomponente 200 zu ermitteln. Beispielsweise kann das Erkennungsmuster auf ein computergestütztes Modell M200 der Steuerungskomponente 200 verweisen, z.B. einen kodierten Link bereitstellen. Das Modell M200 kann beispielsweise ein 3D-CAD Modell der Steuerungskomponente 200 sein und dazu genutzt werden, die vorhandenen Ein- und Ausgänge E200, A200 auf dem transparenten Display INT mit direktem Bezug zur realen Steuerungskomponente 200 darzustellen.

Das transparente Display INT visualisiert vorzugsweise die Ein- und Ausgänge E200, A200 der Steuerungskomponente 200 und die Ein- und Ausgänge E100, A100 des Simulationsmodells 100 in übersichtlicher Weise und zusammen mit der jeweils zugeordneten Signaleingangs- bzw. Signalausgangsinformation. Über das berührungsempfindliche Display INT können die miteinander kompatiblen Eingänge E200 der Steuerungskomponente mit den Ausgängen A100 des Simulationsmodells und die Ausgänge A200 der Steuerungskomponente mit den Eingängen E100 des Simulationsmodells bestimmt und gegenseitig zugeordnet werden. Beispielsweise kann die Zuordnung auf dem transparenten Display grafisch angezeigt und z.B. durch ein manuelles Ziehen einer Verbindung mittels einer Eingabe auf einer berührungsempfindlichen Fläche der interaktiven Anzeigevorrichtung durchgeführt werden. Auf Basis der Zuordnung kann anschließend eine Verschaltung der Ein- und Ausgänge zum Steuern des Simulationsmodells durch die reale Steuerungskomponente erfolgen und derart insbesondere eine Hardware-in-the-Loop-Simulation durchgeführt werden.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Verfahren zum Koppeln eines Simulationsmodells (100) eines realen technischen Systems mit einer Steuerungskomponente (200) des technischen Systems mittels einer interaktiven Anzeigevorrichtung, umfassend die folgenden Verfahrensschritte:
- Ermitteln (S1a) von Eingängen (E100) mit einer jeweils zugeordneten Signaleingangsinformation und Ausgängen (A100) mit einer jeweils zugeordneten Signalausgangsinformation des Simulationsmodells (100),
- Ermitteln (S1b) von Eingängen (E200) mit einer jeweils zugeordneten Signaleingangsinformation und Ausgängen (A200) mit einer jeweils zugeordneten Signalausgangsinformation der Steuerungskomponente (200),
- Darstellen (S2) der Ein- und Ausgänge (E200, A200) der Steuerungskomponente (200) und der Ein- und Ausgänge (E100, A100) des Simulationsmodells (100) mittels der interaktiven Anzeigevorrichtung (INT),
- Zuordnen (S3) von Ausgängen (A200) der Steuerungskomponente zu geeigneten Eingängen (E100) des Simulationsmodells und/oder Eingänge (E200) der Steuerungskomponente zu geeigneten Ausgängen (A100) des Simulationsmodells anhand der Darstellung der Ein- und Ausgänge (E200, A200) der Steuerungskomponente und der Darstellung der Ein- und Ausgänge (E100, A100) des Simulationsmodells und abhängig von der jeweils zugeordneten Signaleingangs- und Signalausgangsinformation und
- Koppeln (S4) der Ein- und Ausgänge (E200, A200) der Steuerungskomponente (200) mit den zugeordneten Ein- und Ausgängen (E100, A100) des Simulationsmodells zum Steuern des Simulationsmodells (100) des realen technischen Systems durch die Steuerungskomponente (200).

2. Verfahren nach Anspruch 1, wobei die Steuerungskomponente mittels eines Sensors erfasst wird, wobei die Sensordaten mindestens eine Typinformation der Steuerungskomponente umfassen und anhand der Typinformation die Ein- und Ausgänge (E200, A200) der Steuerungskomponente ermittelt werden.

3. Verfahren nach einem der vorhergehenden Ansprüche, wobei die Ein- und Ausgänge (E200, A200) der Steuerungskomponente (200) anhand eines computergestützten Modells (M200) der Steuerungskomponente (200) ermittelt werden.

4. Verfahren nach einem der vorhergehenden Ansprüche, wobei die Ein- und Ausgänge (E200, A200) der Steuerungskomponente anhand einer Spezifikation der Steuerungskomponente (200) und/oder einem der Steuerungskomponente (200) zugeordneten Erkennungsmusters ermittelt werden.

5. Verfahren nach einem der vorhergehenden Ansprüche, wobei mindestens eine Typinformation der Steuerungskomponente und/oder Signalausgangs- und/oder Signaleingangsinformation der jeweils zugeordneten Ein- und Ausgänge (E200, A200) der Steuerungskomponente und/oder Ein- und Ausgängen (E100, A100) des Simulationsmodells zusätzlich ausgegeben wird.

6. Verfahren nach einem der vorhergehenden Ansprüche, wobei
- mittels der interaktiven Anzeigevorrichtung (INT) ein Teil der Steuerungskomponente (200) selektiert wird,
- lediglich die Ein- und Ausgänge des selektierten Teils der Steuerungskomponente (200) dargestellt werden
und
- lediglich zu diesen Ein- und Ausgängen geeignete Ein- und Ausgänge (E100, A100) des Simulationsmodells (100) zugeordnet werden.

7. Verfahren nach einem der vorhergehenden Ansprüche, wobei das Simulationsmodell (100) des realen technischen Systems durch die Steuerungskomponente (200) gesteuert (S5) wird.

8. Interaktive Anzeigevorrichtung (INT), die mindestens eine Anzeigeeinheit und mindestens eine Benutzerschnittstelle umfasst,
- wobei die Anzeigeeinheit derart eingerichtet ist, Ein- und Ausgänge (E200, A200) einer Steuerungskomponente (200) und Ein- und Ausgänge (E100, A100) eines Simulationsmodells (100) eines realen technischen Systems darzustellen,
- wobei die Benutzerschnittstelle derart eingerichtet ist, die Ausgänge (A200) der Steuerungskomponente zu geeigneten Eingängen (E100) des Simulationsmodells und/oder Eingänge (E200) der Steuerungskomponente zu geeigneten Ausgängen (A100) des Simulationsmodells anhand der Darstellung der Ein- und Ausgänge (E200, A200) der Steuerungskomponente und der Darstellung der Ein- und Ausgänge (E100, A100) des Simulationsmodells und abhängig von einer jeweils zugeordneten Signaleingangs- und Signalausgangsinformation zuzuordnen.

9. Interaktive Anzeigevorrichtung (INT) nach Anspruch 8, wobei die interaktive Anzeigevorrichtung (INT) mindestens einen Sensor umfasst und/oder mit mindestens einem Sensor gekoppelt ist, wobei der Sensor derart eingerichtet ist, die Steuerungskomponente (200) zu erfassen und Sensordaten, die mindestens eine Typinformation der Steuerungskomponente umfassen, an die interaktive Anzeigevorrichtung (INT) zu übermitteln.

10. Interaktive Anzeigevorrichtung nach Anspruch 8 oder 9, wobei die interaktive Anzeigevorrichtung (INT) derart eingerichtet ist, einen Teil der Steuerungskomponente (200) zu selektieren, lediglich die Ein- und Ausgänge des selektierten Teils der Steuerungskomponente (200) darzustellen und lediglich zu diesen Ein- und Ausgängen geeignete Ein- und Ausgänge (E100, A100) des Simulationsmodells (100) zuzuordnen.

11. Vorrichtung (300) zum Koppeln eines Simulationsmodells (100) eines realen technischen Systems mit einer Steuerungskomponente (200), wobei die Vorrichtung (300) mindestens einen Prozessor (P) und eine interaktive Anzeigevorrichtung (INT) umfasst und derart eingerichtet ist, die Schritte eines Verfahrens nach einem der Ansprüche 1 bis 7 durchzuführen.

12. Computerprogrammprodukt eingerichtet zum Ausführen eines Verfahrens nach einem der Ansprüche 1 bis 7.

13. Computerlesbares Speichermedium mit einem Computerprogrammprodukt nach Anspruch 12.
